# EUROPEAN PATENT APPLICATION

(11) **EP 1 246 272 A2**
(43) Date of publication of application: **02.10.2002**
(21) Application number: 02252243.7
(22) Date of filing: 27.03.2002
(51) Int. Cl.: H01L 51/20

(54) **Sealing structure of organic electroluminescent display**

(30) Priority: 30.03.2001 JP 2001101133
(71) Applicant: Sanyo Electric Co., Ltd., Moriguchi-shi, Osaka (JP)
(72) Inventor: Matsuoka, Hideki, 2-54, Akanabehishino, Gifu-shi, Gifu (JP)
(74) Representative: Cross, Rupert Edward Blount

(57) **Abstract**

To provide a sealing structure for an organic electroluminescent display which enables adequate bonding of a sealing member to a substrate and which does not contribute to deterioration of an organic electroluminescent element during manufacture, an organic electroluminescent element 12 is formed on a substrate 10, and the organic electroluminescent element 12 is sealed by bonding a sealing member 14, configured of a material such as sheet glass, to the substrate 10 with an adhesive agent 16 consisting of an ultraviolet curing resin. Dry nitrogen is sealed in the sealing structure.

## Description

### BACKGROUND OF THE INVENTION

### Field of the Invention

The present invention relates to an improvemed sealing structure for an organic electroluminescent display comprising an organic electroluminescent element formed on a substrate.

### Description of the Related Art

Conventionally, there has been proposed organic electroluminescent displays having an organic electroluminescent element comprising a TFT, an organic luminescent layer, or the like, formed on a substrate. Because such organic electroluminescent elements rapidly deteriorate when exposed to any moisture, they cannot be directly exposed to air. Therefore, to prevent exposure to moisture and air, organic electroluminescent elements are generally sealed with an airtight sealing member.

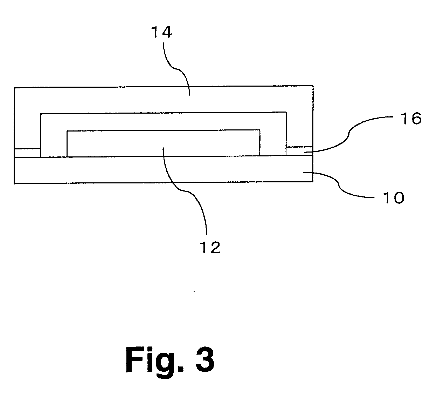

Fig. 3 shows a sectional diagram of an example sealing structure of such a conventional organic electroluminescent display. In Fig. 3, an organic electroluminescent element 12 is formed on a substrate 10 and its periphery is covered with a metallic sealing member 14. The sealing member 14 is bonded to the substrate 10 with an adhesive agent 16 to provide a structure to seal the organic electroluminescent element 12, in which dry nitrogen is then sealed.

However, the sealing structure of the above-described conventional organic electroluminescent display has a disadvantage in that, when a photo-setting resin is used as the adhesive agent 16, light for curing the photo-setting resin must be projected from the side of the substrate 10 because the sealing member 14 is made of metal. This necessity severely limits production. There is also a problem that the overall size must be made sufficiently large to provide a sealing region to which the adhesive agent 16 can be applied; this disadvantageously increases both the weight and size of the device.

It is also necessary to bond the sealing member 14 to the substrate 10 with high bonding strength to prevent moisture from entering within the sealing structure.

### SUMMARY OF THE INVENTION

The present invention was made in view of the above circumstances, and it is an object of the invention to provide an organic electroluminescent display sealing structure which can adequately bond a sealing member to a substrate and which does not contribute to deterioration of an organic electroluminescent element during manufacture.

In order to achieve the above object, the present invention is directed to a sealing structure of an organic electroluminescent display for excluding air from an organic electroluminescent element formed on a substrate, wherein a sealing member made of glass for sealing the organic electroluminescent element is bonded to the substrate with an ultraviolet curing resin. The sealing member transmits 50% or more of light in a wavelength of 300 to 320 nm.

With such a structure, the glass sealing member is bonded to the substrate with the ultraviolet curing resin, and, because this sealing member is one which exhibits high transmittance of ultraviolet light (light with a wavelength of 300 to 320 nm), the sealing member can be bonded firmly to the substrate. By a employing an ultraviolet curing resin with absorbing efficiency of light at a wavelength in a low region at 300 to 320 nm, a resin resistant to heat generation can be chosen. For this reason and because, unlike in the conventional art, heat curing is unnecessary, the organic electroluminescent element will not be exposed to thermal stresses.

In the sealing structure of the organic electroluminescent display, the sealing member may be sheet glass.

By employing the structure of the present invention, material costs can be reduced and, because the sealing member is made of a material such as sheet glass, manufacturing flexibility is enhanced because light for curing the photo-setting resin can be irradiated from any side of the sealing member. This in turn allows further manufacturing cost reductions and increased manufacturing efficiency.

### BRIEF DESCRIPTION OF THE DRAWINGS

Fig. 1 is a sectional diagram of an embodiment of a sealing structure of an organic electroluminescent display according to the present invention;
Fig. 2 is a diagram showing light transmittance of glass as a material for a sealing member used in the embodiment and light absorbing efficiency of an ultraviolet curing resin used as an adhesive agent; and
Fig. 3 is a sectional diagram of an example sealing structure of a conventional organic electroluminescent display.

### DESCRIPTION OF THE PREFERRED EMBODIMENT

An embodiment of the present invention will be described with reference to the accompanying drawings.

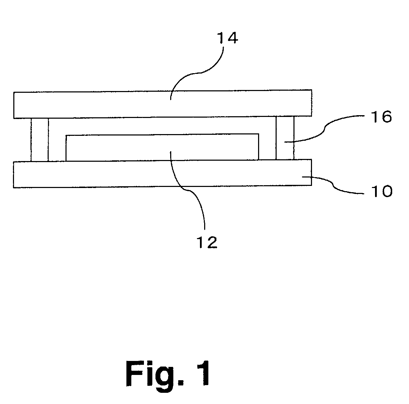

Fig. 1 shows a sectional diagram of an embodiment of the sealing structure of an organic electroluminescent display according to the present invention. In the structure shown in Fig. 1, an organic electroluminescent element 12 is formed on a substrate 10. A sealing member 14 is bonded to the substrate 10 with an adhesive agent 16 consisting of an ultraviolet-curing resin to form an airtight seal for the organic electroluminescent element 12. In the present embodiment, the sealing member 14 is made of sheet glass, which is an example material transmitting 50% or more of ultraviolet light, more particularly light in the 300 to 320 nm band. Thus, a curing reaction of the adhesive agent 16 sufficient to produce the sealing structure according to this embodiment can be ensured, and sufficiency of the strength of the bond of the sealing member 14 to the substrate 10 can be relied upon. A suitable gas, such as dry nitrogen, is sealed into a void space of the sealing structure comprised of the substrate 10, the sealing member 14 and the adhesive agent 16.

Thus, when an appropriate ultraviolet curing resin is used as the adhesive agent 16 for bonding the sealing member 14 to the substrate 10, the organic electroluminescent element 12 inside the sealing structure is less subject to deterioration, and the service life of the element can be extended because the resin provides superior waterproofing. When a thermosetting resin is used as the adhesive agent 16, it is necessary to heat the adhesive agent 16 to bond the sealing member 14 to the substrate 10. This exposes the organic electroluminescent element 12 to high temperatures and increased risk of deterioration. Heating is not required when an ultraviolet curing resin is used and, when the light irradiated to cure the resin has a wavelength of 300 to 320 nm and the resin absorbs light in such a short wavelength region, very little heat is produced. Accordingly, thermal deterioration of the organic electroluminescent element 12 can be prevented and the element life can be extended. Further, distortion of the glass substrate due to heat, as is common in the conventional art, can be prevented.

The sheet glass sealing member 14 according to the present example can be easily produced and material production costs can be reduced.

Furthermore, to bond the sealing member 14 to the substrate 10 with the adhesive agent 16 which is an ultraviolet curing resin, ultraviolet rays can be irradiated from either side of the substrate 10 and the sealing member 14. Therefore, the sealing structure of the organic electroluminescent display according to this embodiment enables improvement of the flexibility of the production method. When the present invention is applied to devices wherein a peripheral driver for driving the organic electroluminescent display is formed on the substrate 10, because light can be irradiated from the side of the sealing member 14 it is not necessary to provide a sealing area for application of the adhesive agent 16, as required in the related art. As such, further miniaturization becomes possible.

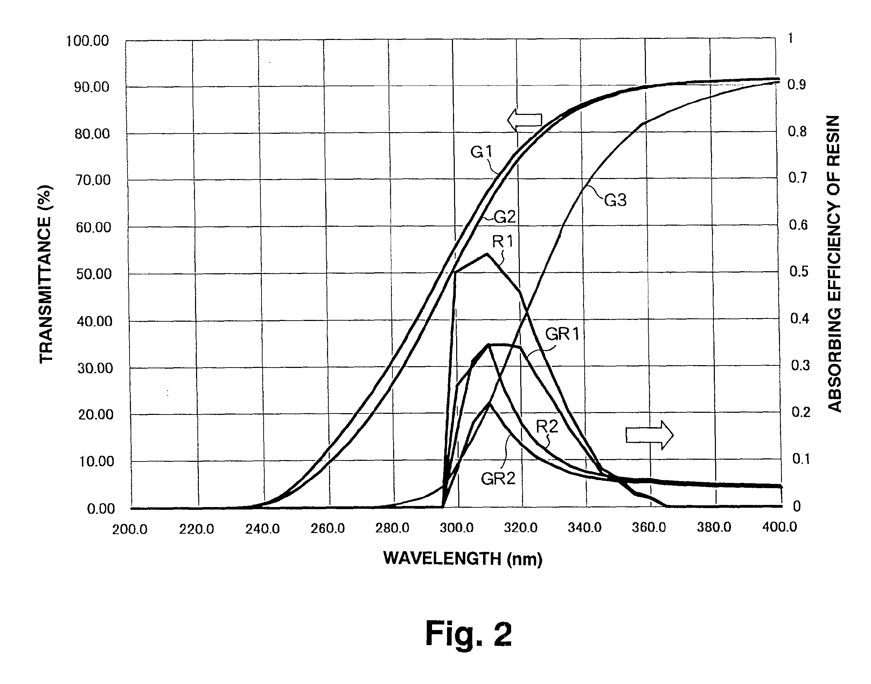

Fig. 2 is a diagram showing light transmittance of glass as a material for the sealing member 14 of the present invention, and light absorbing efficiency of the ultraviolet curing resin used as the adhesive agent 16 for different wavelengths of light. Transmittance characteristics of three types of glass materials G1, G2, G3 are shown in Fig. 2. For the ultraviolet curing resin, 2 types of absorbing efficiency, R1 and R2, are shown.

It is apparent from Fig. 2 that the light absorbing efficiency of the ultraviolet curing resin is high in the ultraviolet region, and particularly high in the 300 to 320 nm region. The glass materials G1, G2 shown in Fig. 2 transmit 50% or more of light with a wavelength in a range of 300 to 320 nm, the region in which the light absorbing efficiency of the ultraviolet curing resin is especially high. The glass material G3, on the other hand, exhibits low transmittance of light in the 300 to 320 nm wavelength range, and, therefore, the glass material G3 is judged to be an inappropriate material for the sealing member 14 of the present invention.

When the glass materials G1, G2 shown in Fig. 2 are used as a material for the sealing member 14, the product of the light transmittance and the light absorbing efficiency of the ultraviolet curing resin is shown as GR1 and GR2 for respective types of ultraviolet curing resins. A rate of curing reaction of the ultraviolet curing resin can be determined from the product of the light transmittance of the sealing member 14 and the light absorbing efficiency of the ultraviolet curing resin. More specifically, the curing reaction becomes faster as the product becomes larger, enabling firm bonding of the sealing material 14 to the substrate 10. As shown in Fig. 2, when the glass materials G1, G2 are used as the material for the sealing member 14, the product of the transmittance by the absorbing efficiency of light having a wavelength of 300 to 320 nm becomes large (see GR1, GR2), and a bonding strength of the adhesive agent 16 of the photo-curing resin can be sufficiently enhanced.

Non-alkali glass which is also used as a material for the substrate 10, can be used as glass exhibiting high transmittance of light in the 300 to 320 nm range. An example of a suitable ultraviolet curing resin may be cationic epoxy resin or the like.

As described above, because according to the present invention the sealing member is configured of a material such as glass transmitting 50% or more of light with a wavelength of 300 to 320 nm, the bonding strength of the ultraviolet curing resin for bonding the sealing member to the substrate can be enhanced sufficiently.

Production can be facilitated and the material cost can be reduced by using a suitable common materials such as sheet glass for the sealing member.

While there has been described that what is at present considered to be a preferred embodiment of the invention, it is to be understood that various modifications may be made thereto, and it is intended that the appended claims cover all such modifications as fall within the true spirit and scope of the invention.

## Claims

1. A sealing structure for providing an airtight seal for an organic electroluminescent element formed on a substrate for an organic electroluminescent display, wherein a sealing member made of a transparent material for sealing the organic electroluminescent element is bonded to the substrate with an ultraviolet curing resin, said sealing member **characterized in that** it transmits 50% or more of light with a wavelength of 300 to 320 nm.

2. The sealing structure according to claim 1, wherein the sealing member is made of sheet glass.

3. The sealing structure according to claim 1 or 2, wherein the sealing member is made of non-alkaline glass.

4. The sealing structure according to any of claims 1 to 3, wherein dry nitrogen is sealed within a void space of the sealing structure.

5. The sealing structure according to claim 4, wherein dry nitrogen is sealed within the void space comprised of two glasses and the ultraviolet curing resin.

6. The sealing structure according to claim 5, wherein the two glasses are the substrate and the sealing member.

7. The sealing structure according to any of claims 1 to 6, wherein the ultraviolet curing resin is a cationic epoxy resin.
